# EUROPEAN PATENT SPECIFICATION

(11) **EP 0 373 764 B1**
(45) Date of publication and mention of the grant of the patent: **22.03.1995**
(21) Application number: 89311681.4
(22) Date of filing: 10.11.1989
(51) Int. Cl.: H03M 13/00

(54) **Correction of random and burst errors**
Korrektur von Burst- und Zufallsfehlern
Correction d'erreurs aléatoires et multiples

(30) Priority: 14.12.1988 US 284979
(43) Date of publication of application: 20.06.1990
(73) Proprietor: International Business Machines Corporation, Armonk, N.Y. 10504 (US)
(72) Inventor: Abdel-Ghaffar, Khaled, Nr.120 Davis, CA 95616 (US); Hassner, Martin Aureliano, Palo Alto, CA 94306 (US)
(74) Representative: Moss, Robert Douglas

(56) References cited:
- EP-A- 0 218 413
- IEEE TRANSACTIONS ON INFORMATION THEORY. vol. 37, no. 3, May 1991, NEW YORK US pages 735 - 741; K. ABDEL-GHAFFAR ET AL.: "Multilevel error-control codes for data storage channels"
- IEEE TRANSACTIONS ON CONSUMER ELECTRONICS. vol. 33, no. 4, November 1987, NEW YORK US pages 540 - 550; K. KUTARAGI et al.: "A new 2-inch data disk system with a high transfer rate"

## Description

This invention relates to the correction both random and burst errors in, for example, data recorded on a storage medium in blocks comprising sub-blocks.

In US-A-4 706 250, there is disclosed a two-level error correction code structure in an improved multibyte error-correcting subsystem. Data is formatted on a disk track into a number of sub-blocks, each within a respective block. There are also two sets of three sub-block check bytes. One set is associated with the even phases and the other with the odd phase, this being due to two-phase interleaving.

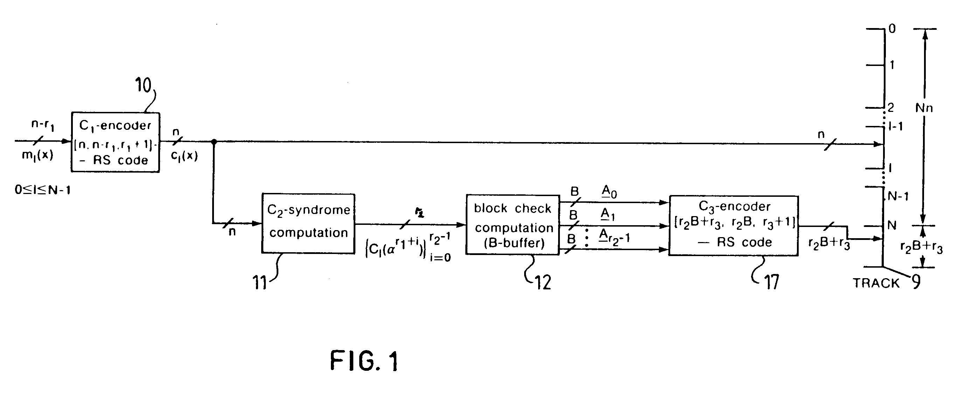

With the '250 arrangement, it is possible to correct one error in each sub-block at a first (sub-block) level of correction, and correct two errors in one of the sub-blocks of the block at a second (block) level of correction. Thus, if there are two or more errors in a sub-block, due for example to an error burst, the ECC will be unable to correct all the errors. To partially address this problem, the size of the sub-blocks could be reduced from say 100 bytes to 50 bytes to reduce the likelihood that more than one error would occur in each sub-block. But, associated with each sub-block (as shown in Fig. 1 of '250) is a set of sub-block check bytes which, as illustrated, are two-way interleaved. Hence doubling the number of sub-blocks doubles the number of sub- block check bytes, thus increasing the overhead.

In the co-pending application 89308569.6 (published as EP-A-0 360 424 on 25/01/89), method and means are disclosed capable of correcting both random conventional errors and a long burst error of up to N consecutive bytes in a two-level ECC system. This is achieved by adding at the end of each block a series of N sequential parity check bytes. During reading, after the generation of the ECC syndromes, parity syndromes are generated by comparing parity check bytes computed from the data bytes and check bytes as read with the parity check bytes as written. Each syndrome is a byte in length. In response to a long-burst error, a pointer is generated to the first of N consecutive bytes in a block that could have been influenced by the error. Then those ECC syndromes not dependent on the N bytes identified by the pointer are used to correct any correctable errors. Following this, the parity syndromes are adjusted according to the errors thus corrected. The adjusted parity syndromes are then used to correct correctable errors in the N bytes indicated by the pointer. Any unused ECC syndromes are adjusted according to the errors thus corrected by the adjusted parity syndromes; whereupon the adjusted ECC syndromes are used to correct all correctable errors then remaining. This method and means operates satisfactorily but requires that N parity bytes be added at the end of each block in order to correct an error burst N bytes long, and requires a pointer to each error burst.

It is considered desirable to provide an improved two-level ECC system of the above general type capable of locating any preselected number of sub-blocks in error containing up to a preselected number of bytes in error, whether non-consecutive or in bursts. The present invention provides a

The present invention equally provides a method of correcting multiple error bursts in data received in blocks - as, for example, read from data blocks recorded on a storage medium - each block comprising a plurality of sub-blocks of data bytes and sub-block check bytes, and block level syndromes from which block check syndromes are generated and stored after the last sub-block of the block, from which decoded and estimated block check syndromes are generated during reading, comprising the steps, after reception of the data, of:
algebraically summing the decoded block check syndromes and the estimated block check syndromes to provide a set of block check syndromes for a code for locating up to T sub-blocks having an error burst for which no externally generated pointers are available;
decoding the set of syndromes for identifying each the sub-block having an error burst; and
computing block level syndromes identifying the locations and the values of the errors within the sub-blocks having error bursts and no pointers.

The present invention equally provided apparatus for performing such a method.

There are disclosed hereinafter, by way of example, a method and means for correcting multiple burst errors in a storage medium on which data is recorded in blocks that comprise sub-blocks of data bytes and redundant check bytes for which decoded and estimated block syndromes are generated during reading. After reading the data, the decoded block syndromes for each block are algebraically summed with the estimated block syndromes for that block to provide a set of syndromes for a code which locates sub-blocks in that block having error bursts. This set of syndromes is then decoded to generate algebraic pointer(s) to identify each sub-block having an error burst. Thereafter block syndromes for each sub-block having an error burst are computed at 33 and used in conjunction with previously computed sub-block syndromes from 20 for those sub-blocks and both sets of syndromes are decoded to identify the locations and the values of the errors within those sub-blocks having error bursts.

The location of the sub-blocks in error may be specified either by an externally generated pointer or the location may be unknown, without reducing first (sub-block) level correction capability.

The present invention will be described further by way of example with reference to embodiments thereof as illustrated in the accompanying drawings, in which
Fig. 1 is a schematic block diagram of one form of encoder portion of a storage correction arrangement;
Fig. 2 is a schematic block diagram showing in more detail portions of the arrangement of Fig. 1 which compute block check bytes; and
Fig. 3, in sections A- D, is a block diagram of the decoder portion of the arrangement.

The arrangements selected for further description to illustrate the invention are shown applied to a two-level ECC system of the type disclosed in the above-cited US-A-4,706,250. As shown in Fig. 1 thereof, data is recorded in blocks of variable (or fixed) length each comprising a plurality of sub-blocks, of the same length except possibly the last. Each sub-block comprises a variable (orfixed) number of data bytes and six sub-block check bytes for first level (sub-block) error correction. At the end of the last sub-block in the block are four CRC bytes for data integrity checking, followed by two block check bytes for second level (block) error correction.

In this two-level ECC system, the data is encoded on the sub-block (first) level by a Reed-Solomon (RS) [n, n-rₗ, rᵢ+1]-encoder, where n is the number of bytes in the encoded sub-block, r₁ is the number of sub-block check bytes in the encoded sub-block, and r₁+1 is the minimum Hamming distance or the separation achieved among sub-blocks. This distance suffices for the correction of up to t₁ = |r₁/2| byte errors in a sub-block. The fundamental feature of this prior art two-level architecture is to compute r₂ block level syndromes for a second [n, n-r₂, r₂+1] - RS code. These syndromes are computed for each sub-block in a block and added cumulatively to produce r₂ block check bytes which are shared by all sub-blocks. These block check bytes are stored after the last sub-block in a block.

If the location of a sub-block with an error burst is specified by an externally generated pointer and the number of errors in that sub-block does not exceed |r₁/2|, then the errors can be corrected by a sub-block level decoder. If the number of errors does not exceed |(r₁ +r₂)/2 |, then the errors may be corrected by combining the correction power of the sub-block and block level check bytes.

If the location of the sub-block with an error burst is unknown, however, this prior art two-level ECC system can locate the sub-block with the error burst and correct the error burst provided the number of errors (i.e. its weight) does not exceed |r₁/2| + c. This burst location and correction is achieved at the cost of lowering the maximal sub-block error correction capability in all other sub-blocks from |r₁/2| to |r₁/2| - c, where c is a fixed design parameter which is a positive integer such that

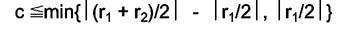

It should be noted that, in Figs. 1-3, a diagonal slash across an input or output signifies that it consists of the specified number of bytes in parallel. Also, as hereinafter used, the term "error burst" is defined as any number of bytes with errors, whether or not the errors are consecutive, where this number exceed the first level (i.e., sub-block) correction capability of the apparatus.

Four parameters are used to establish the error correction capability of the two-level ECC apparatus. These are r₁, r₂, r₃ and B where:
r₁ is the number of sub-block (first level) check bytes per sub-block;
r₂ is the number of block (second level) check bytes per block;
r₃ is the number of the check bytes for the block check bytes, the number being sufficient so that all of the bytes in a block are equally protected; and

B a 2T + S, where T and S denote the numbers of correctable sub-blocks with error bursts without and with, respectively, externally generated pointers to the correctable sub-blocks with error bursts. Thus, if B=4, correction can be achieved if T = 0, with S Z 4; if T = 1, with S Z 2; and with T = 2, with S = 0. The maximal number of errors in a sub-block that can be corrected is

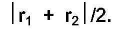

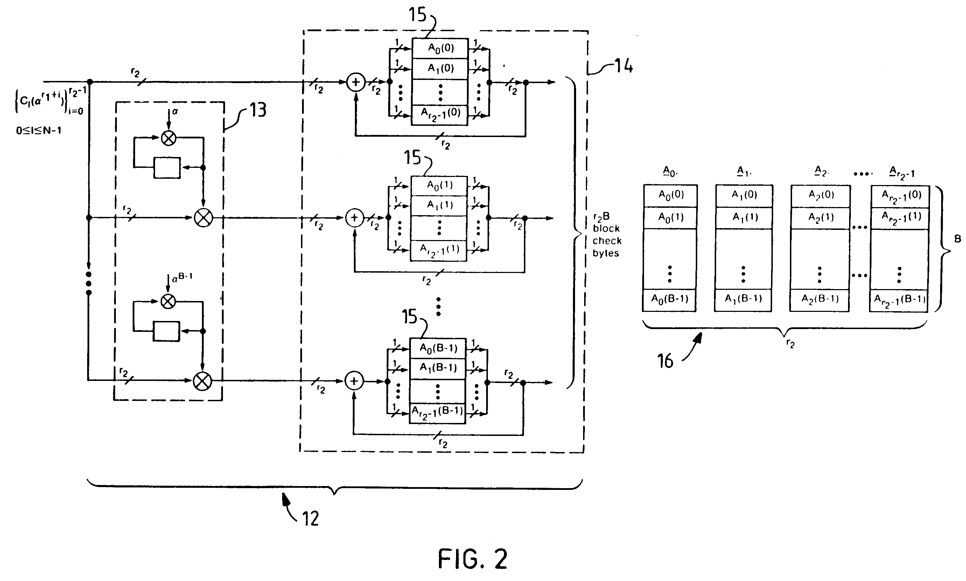

As illustrated in Fig. 1, an encoder 10 encodes (n - r₁) bytes of data. The encoded n bytes of data are stored in a data field on a disk track 9. The encoded data is also supplied to syndrome computation circuitry 11 which generates r₂ block syndromes for each of the sub-blocks of the block. As earlier noted, each syndrome is one byte in length. These r₂ syndromes are supplied to block check computation circuitry 12 which, as shown in Fig. 2, comprises circuitry 13 and 14.

Circuitry 13 comprises means for multiplying the r₂ block syndromes for each sub-block by a series of preselected cumulative weighting factors {α^{l}, ..., α^{l(B-1)}} according to the location index I of the sub-block within the block, where a is the primitive generator of the Galois finite field.

The different factor-weighted syndromes from each of the B buffers 15 are cumulatively summed by circuitry 14 for all the sub-blocks within the block to generate a total of r₂B block syndromes, which are reordered in a preselected fashion as shown at 16. After the last sub-block of the block is written, encoder 17 (Fig. 1) encodes the r₂B block check syndromes and appends to them r₃ additional check bytes. The r₂B block check syndromes plus the r₃ additional check bytes are then stored at the end of the block on disk track 9 following the last sub-block, N, in the block.

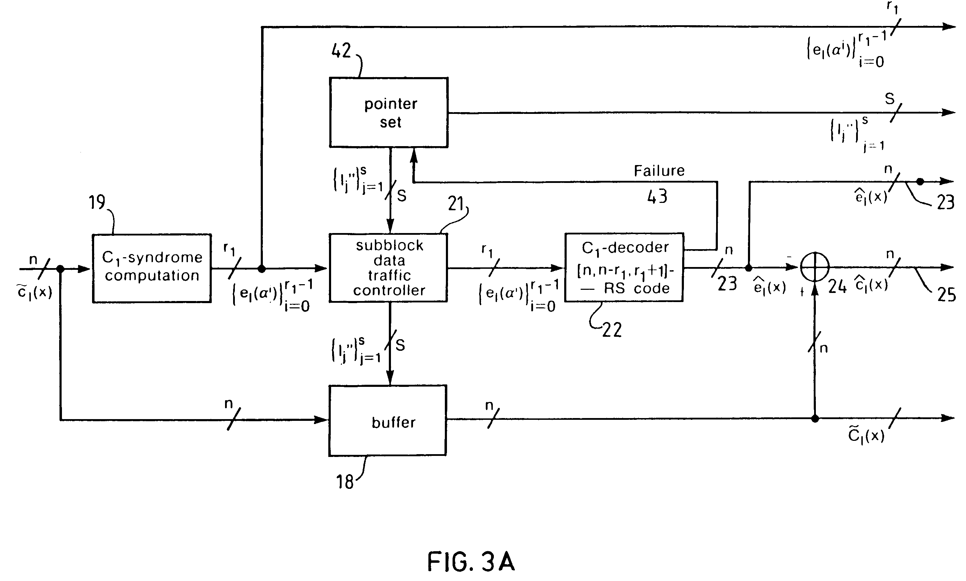

During reading of the data, and as illustrated in Fig. 3A, the n data bytes as read from each sub-block of a block are stored in a buffer 18 and also concurrently fed to sub-block syndrome computation circuitry 19. Circuitry 19 computes, for each sub-block, sub-block syndromes that are stored in a buffer 20. Those sub- block syndromes that do not correspond to a sub-block with an error burst are passed through a sub-block data traffic controller 21 to a decoder 22. Externally generated pointers to sub-blocks with error bursts, if available, are also supplied to controller 21 stored in a location register 42. Decoder 22 produces in bus 23 an estimated error pattern for each of the sub-blocks without error bursts. These estimated error patterns in bus 23 are algebraically summed at 24 with the sub-block data stored in buffer 18 to correct all correctable errors in these sub-blocks without error bursts and thereby provide in bus 25 corrected sub-block data for those sub-blocks without error bursts.

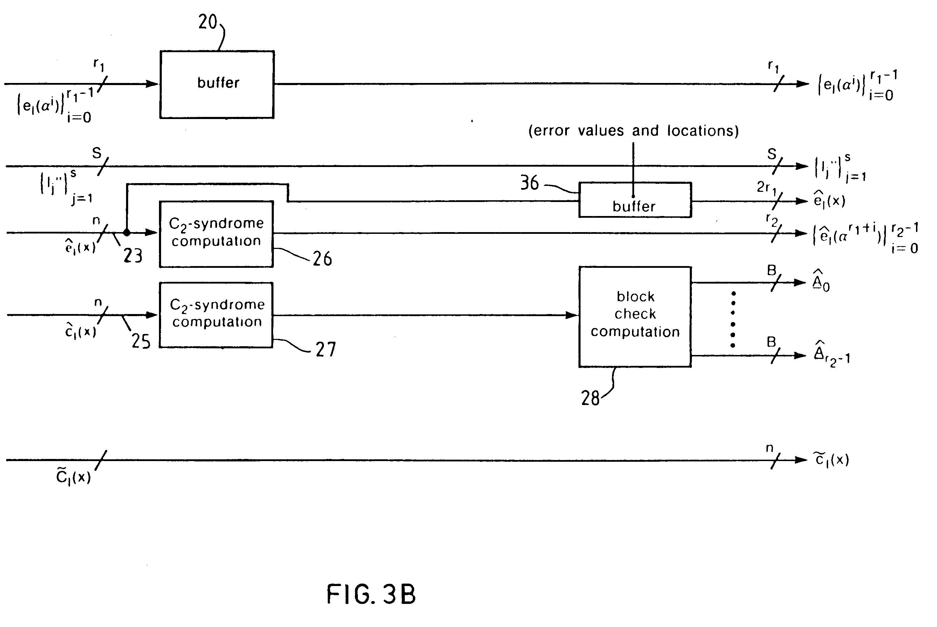

Block level syndromes are then computed for each sub-block from the estimated error pattern (in 23) by circuitry 26 (Fig. 3B) and from the corrected sub-block data (in 25) by circuitry 27. Using block check byte computation circuitry 28 identical with that described for circuitry 12, the block level syndromes for the corrected sub-block data are multiplied by the aforementioned series of preselected cumulative weighting factors according to their order of occurrence within the block and each block level syndrome as multiplied by a different weighting factor is stored in a respective one of the B buffers 15; and then these factor-weighted syndromes from the B buffers 15 are cumulatively summed to produce estimated block check syndromes covering all the sub-blocks of that block.

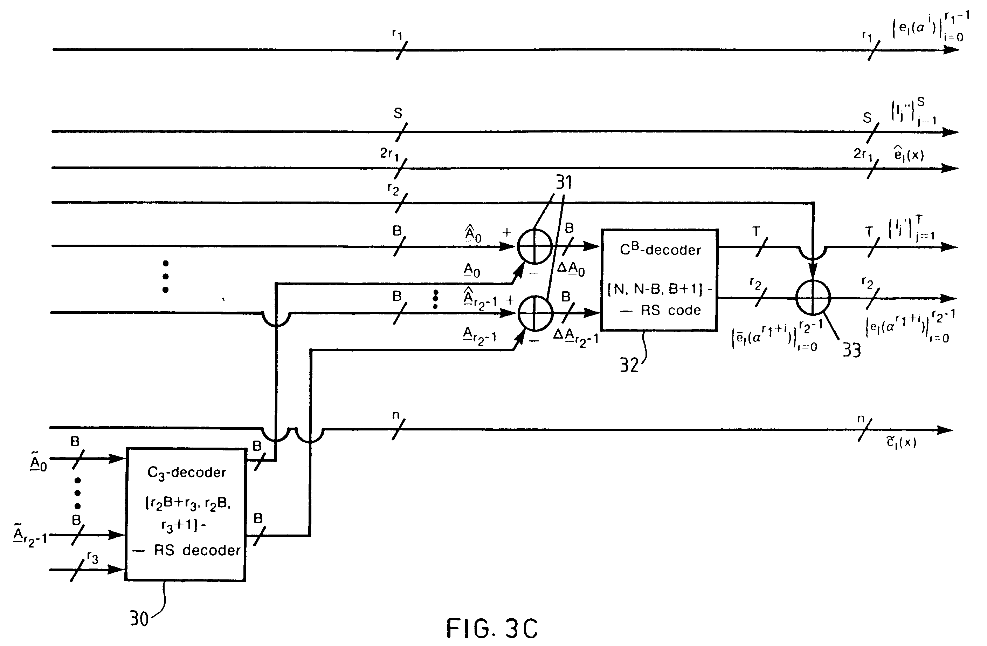

Decoder 30 (Fig. 3C) decodes the encoded block check syndromes generated during writing for all sub-blocks of each block. Each of these decoded block check syndromes is then algebraically summed with its corresponding estimated block check syndrome by a respective summing circuit 31 to provide a set of block check syndromes for a code for locating those sub-blocks having error bursts. Decoder 32 then decodes this set of block check syndromes to produce up to T algebraic pointers to the sub-blocks with error bursts. Concurrently, for each sub-block with an error burst, decoder 32 produces a set of r₂ block level syndromes. Due to the effect of miscorrection at the sub-block level, these r₂ block level syndromes must be updated. This is done by algebraically summing at 33 the block level syndromes computed by decoder 32 with the block level syndromes computed by circuitry 26 from the estimated error pattern syndromes to produce block level syndromes in bus 34 for the true error pattern for those sub-blocks having error burst.

Subblock data traffic controller 35 has as inputs:
n representing the data bytes as read;
S representing updated externally generated pointers from updated pointer set 42 to sub-blocks with error bursts;
T representing algebraic pointers obtained from decoder 32 to sub-blocks with error bursts;
* the estimated error pattern from bus 23 that had been stored in a buffer 36 (Fig. 3B), and
* the block level syndromes for the true error pattern from bus 34.

For those sub-blocks without an error burst, controller 35 directs the n data bytes as read and the buffered 2rᵢ bytes for the estimated error pattern from buffer 36 to an algebraic summing circuit 37 to correct all sub-blocks without error bursts.

For those sub-blocks with error bursts, controller 35 directs to decoder 39 r₂ block syndromes for the true error pattern from bus 34 and also the r₁ sub-block syndromes from buffer 20 for only those sub-blocks with error bursts. From these inputs decoder 39 produces an error pattern that is algebraically summed at 40 with only those of the sub-blocks as read which contain error bursts to provide a block of data in bus 41 in which all errors and erasures have been corrected up to the preselected capability of the apparatus.

As illustrated, all sub-blocks as read are buffered at 18 and directed to the traffic controller 35; and the controller channels those sub-blocks with error bursts to algebraic summing circuit 40 and those without error bursts via controller 35 to summing circuit 37. However, if preferred, the apparatus could be modified to buffer at 18 only those sub-blocks believed to have error bursts and to send only these via controller 35 to summing circuit 40.

The functions performed by computation circuitry 19 and C₁-decoder 22; by circuitry 26, 27 and C^{B-}decoder 32; by C₃-decoder 30; and by C₁,₂-decoder 39 may be provided by respective separate semiconductor chips, such as the WD60C80 Error Detection and Correction Chip (EDAC) marketed by Western Digital Corp. of Irvine, California.

The encoder portion and decoder portion of the apparatus embodying the invention will now be described in greater detail, followed by an Appendix setting forth the proof establishing the operability and efficacy of the method and means herein disclosed.

Assume that the data alphabet is formally represented by a finite, Galois Field with q symbols that is denoted by GF(q). For practical storage applications q is most commonly taken as 2⁸, i.e., each symbol in GF(2⁸) corresponds to a byte.

The I-th data sub-block consists of the symbols mⱼ,ₗ GF(q), where 0 ≦ j ≦ n - r₁ - 1 and 0 ≦ I ≦ N - 1. This sub-block is first encoded by the sub-block level [n, n-r₁, r₁ + 1] - RS encoder 10. Mathematically, it is convenient to describe this data sub-block in terms of the polynomial

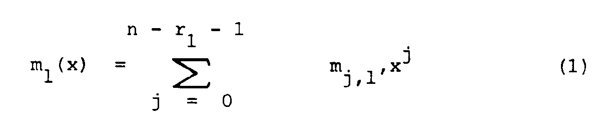

The dummy variable x is introduced so that its powers can represent the order of appearance of the bytes in the sub-block. Thus the j-th byte mⱼ,ₗ appears as the coefficient of xi, 0 ≦ j ≦ n - r₁ - 1, in the polynomial mₗ(x) that represents the I-th sub-block. The polynomial formulation is convenient since it allows for the description of the encoding operation as polynomial multiplication. Encoder 10 for the sub-block level code (C₁-code) is characterised by the encoding polynomial

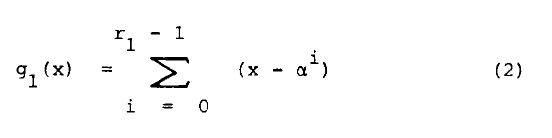

The symbol a in GF(q) denotes a root of a primitive irreducible polynomial whose distinct powers form a representation of the non-zero elements of GF(q). Such a polynomial is a divisor of x^{q-1} - 1. The I-th encoded sub-block is represented by the polynomial

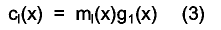

The encoding operation can be described in the frequency transform domain as forcing r₁ zeros at the Galois Field symbol frequencies {αⁱ}, i.e., cₗ(αⁱ) = 0, for 0 ≦ i ≦ r₁ - 1.

The C₁-coded sub-blocks {cₗ(x)}, 0 ≦ i ≦ r₂ - 1, are written on disk track 9 and, as shown in Fig. 1, are also simultaneously processed to produce shared block check syndromes using circuitry 12. The computation of these check syndromes is performed in two steps. In the first step, (see Fig. 1) the block C₂-syndrome values {cₗ,(α^{r}1 +ⁱ)}, 0 ≦ i ≦ r₂- 1, are evaluated at the Galois Field frequencies at which the C₂-zeros are located. These nulls are at {α^{r}1 + ⁱ}, 0 ≦ i ≦ r₂ - 1, the zeros of the encoding polynomial g₂(x) for the C₂-code which is an [n, n-r₂, r₂ + 1] - RS code. The explicit expression for this encoding polynomial is

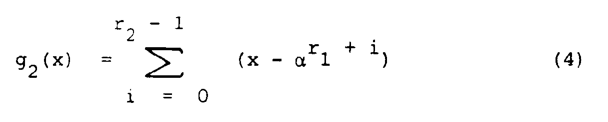

The encoding process as thus far described is known from the prior art. However, according to an important feature of the invention, in the second step each syndrome value cₗ(a^{r}₁ + ⁱ), 0 ≦ i ≦ r₂ - 1, is weighed by a factor a^{bl} and cumulatively-weighted syndrome sums are generated as follows:

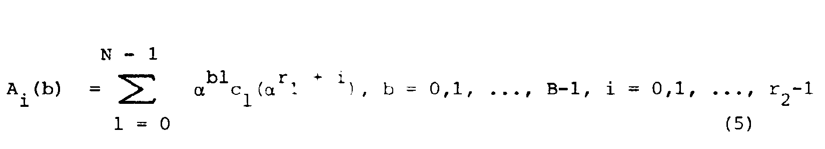

In the weight factor α^{bl}, the parameter I, 0 ≦ I ≦ N - 1 provides the sub-block location inside the block, and the parameter b, 0 ≦ b ≦ B - indexes the B buffers 15 in which these cumulatively-weighted syndromes are computed and which are shown in Fig. 2. The total number of cumulatively-weighted C₂-syndromes is r₂B bytes, which are shared among all the sub-blocks in a block and referred to as block check syndromes. These block check syndromes are generally stored after the last written sub-block in a block.

The block check syndromes have a special status that has to be addressed in the encoding portion. The r₂B block check syndromes computed in Equation (5) differ from the rest of the stored data because they are not protected from errors. This however is easily overcome by encoding them by using [r₂B + r₃, r₂B, r₃ + 1] - RS encoder 17. The parameter r₃ is chosen such that equal error protection for all stored data bytes is achieved.

If random and burst error statistics for the storage channel are available, then r₃ can be chosen such that equal error protection in a probabilistic sense is achieved. However, if accurate statistics are not available, a worst-case choice for r₃ can be made as follows. Typically r₂B is much smaller than n and hence the block check syndromes can be considered as constituting a shortened data sub-block. Assume that the channel can cause, in the worst case, up to t errors and s erasures in any sub-block, such that 2t + s≦r₁ + r₂, where an error is defined as a perturbation, the location and value of which are unknown, and an erasure is defined as a perturbation whose location is known by an external pointer, such that only the value of the error must be computed. Then r₃ = r₁ + r₂ ensures equal error protection for all data bytes. Encoder 17 thus protects the block check syndromes.

The enhanced error correction capability of this two-level architecture composed of the sub-block level [n, n-r₁, r₁ + 1] and block level [n, n-r₂, r₂ + 1] - RS codes C₁ and C₂, respectively, will now be discussed. Let t denote the desired number of correctable errors and s the desired number of correctable erasures in a sub- block. With these values of the desired performance parameters s and t established, the design parameters r₁ and r₂ of the two-level architecture must satisfy the inequality 2t + s ≦ r₁ + r₂ for each sub-block to correct all errors.

A sub-block is declared to have an error burst if its number of errors and erasures satisfy the inequalities r₁ < 2t + s ≦ r₁ + r₂. Let us denote by T the number of sub-blocks with error bursts whose locations are unknown and by S the number of sub-blocks with error bursts whose locations are given by externally generated pointers from set 42, both of which types of errors are to be corrected. If the number of B buffers of length r₂ each, which is the third design parameter of the proposed two-level architecture, is chosen to satisfy the inequality 2T + S ≦ B, then T + S will be the total number of correctable sub-blocks with error bursts. All the other sub-blocks for which 2t + s ≦ r₁ are without burst errors and are correctable by the sub-block level code C₁.

### Detailed Description of Decoder Portion (Figs. 3A-D)

The read back I-th sub-block ₁ (x) differs from the written C₁-encoded sub-block cₗ(x) by the error pattern polynomial e(x) as follows: 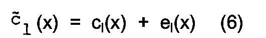 where

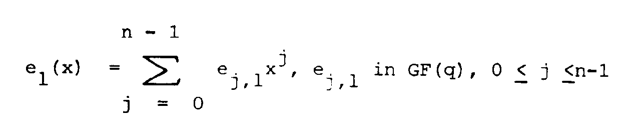

The first step in the decoding process is computing the C₁-syndromes ₁ (αⁱ), 0 ≦ i ≦ r₁-1 with circuitry 19. Since by definition cₗ(αⁱ) = 0, 0≦ i ≦ r₁-1, the C₁-syndromes are as follows:

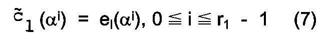

These syndromes are computed for all read back sub-blocks. In the next step C₁-decoder 22 processes these syndromes to produce a minimal Hamming distance estimate êₗ(x) of the error pattern polynomial which is algebraically summed at 24 with the buffered read back sub-block polynomial ₁ (x). This computation is performed only on those sub-blocks which do not have pointers. The processing of the C₁-syndromes of all the other sub-blocks is deferred to the C₁,₂-decoder 39. C₁-decoder 22 produces an estimated C₁-codeword 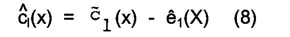 where ê₁ is the estimated error pattern.

If the I-th sub-block has no error bursts, C₁-decoder 22 generates an estimated error pattern êₗ(x) that is identical with the actual error pattern e(x). Hence, ₗ(x) = cₗ(x). If the I-th sub-block has an error burst and no pointer, attempting to correct it the C₁-decoder 22 will either fail or the error burst will be miscorrected. A decoder failure 43 generates a pointer in 42 that locates the I-th sub-block as a sub-block previously unknown to have an error burst. To include all the sub-blocks of a block in the subsequent discussion, it is assumed that when the location of a sub-block with an error burst is given either by a pointer from 42 or from a failure (see 43) of C₁-decoder 22, then

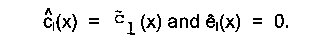

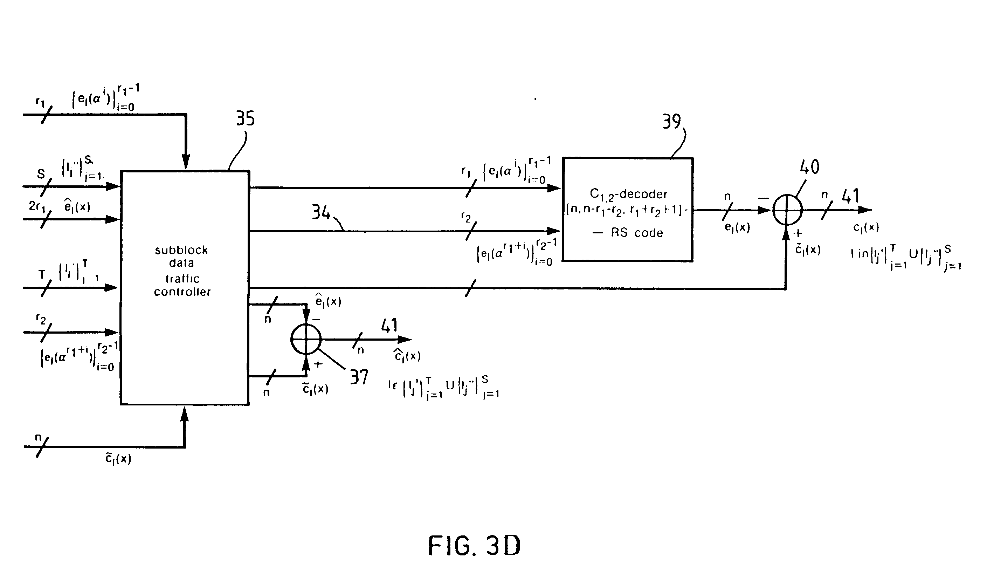

Assume now that the I-th sub-block is miscorrected, i.e., the estimated error pattern êₗ(x) in 23 differs from the actual error pattern e(x). There is the possibility that the miscorrection is a valid C₂-codeword and hence will pass through the decoder 39 shown in Figs. 3D and invalidate the correction capability of the two-level architecture. To prove that this cannot happen, the Appendix includes Lemma 1, an analysis of the properties of the difference error pattern polynomial obtained as the difference between the actual and the estimated error pattern polynomials:

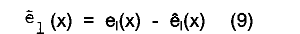

Following the processing in C₁-decoder 22, S, the number of sub-blocks with error bursts whose locations are known is generally increased according to the proportional relationship of 2T + S ≦ B as T, the number of sub-blocks having error bursts with unknown locations is decreased. The new erasures correspond to Cᵢ-decoder failures that are transmitted via 43 to update location register 42.

The next step in the decoding process is the computation (at 26, 27) of the C₂-syndromes of the estimated C₁-codeword ₗ(x) provided (in 25) by the C₁-decoder 22. These syndromes are used as inputs to the computation of the block check syndrome estimates (at 28). This computation is identical to the one described in Fig. 2 for circuitry 12, and the equations for the block syndrome byte estimates, similar to Equation (5), are as follows:

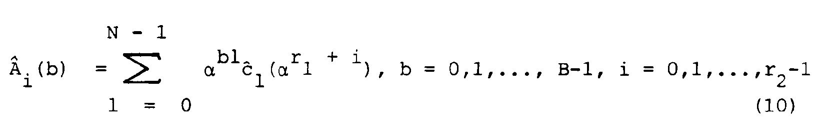

The read back block check syndromes, stored after the last sub-block are restored by the RS C₃-decoder 30. The inputs to this decoder are the noisy r₂B block check syndromes Ãᵢ(b), 0 ≦ b ≦ B-1, 0 ≦ i ≦ r₂-1 and the r₃ check bytes which may also have incurred errors. The output of the decoder 30 is the restored r₂B block check syndromes which are subtracted from the estimates computed in (10) to produce the differences ΔAᵢ(b) = Âᵢ(b) - Aᵢ(b) explicitly given as follows:

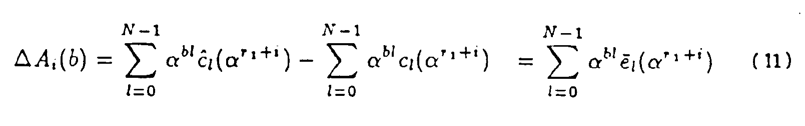

The cumulative block level syndromes are e₁ (α^{r+i}), 0 ≦ I ≦ N-1, 0 ≦ i ≦ r₂-1. By Lemma 1 these are zero if and only if the I-th sub-block has no error bursts. If this I-th sub-block has an error burst, then e₁ is non-zero for some i in the range 0 ≦ i ≦ r₂-1. In terms of these syndromes the i-th cumulative block syndrome polynomial, 0 ≦ i ≦ r₂-1 is defined as follows:

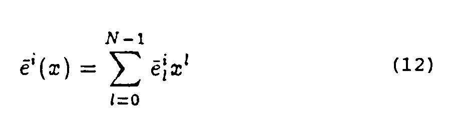

The block check differences ΔAᵢ(b) are the values assumed by the polynomial defined in (12) at the locations a^{b} i.e.

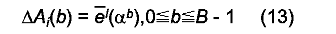

Assume {I'₁,....,I'T} to be the unknown locations and {I"₁,....,I"S} to be the known locations of the sub-blocks with error bursts. The problem to be solved in the sequel is the computation of the unknown burst locations {I'₁,....,I'_{T}} and of the cumulative block syndromes ₁(a^{r}1 ⁺ ), 0 ≦ I ≦ N-1, 0 ≦ i ≦ r₂-1, for each I in the union set of known and unknown locations I e {I'₁,I'₂,....,I'_{T}}V {I"₁,I"₂,....,1"'_{S}} of sub-blocks with error bursts. This problem is solved by introducing a novel interpretation of the cumulative block syndrome polynomials ⁱ (x), 0 ≦ i ≦ r₂-1. For a fixed i, (x) may be viewed as an error pattern polynomial for the whole block which consists of N sub-blocks, now viewed as a codeword in a [N, N-B, B + 1] - RS code, denoted by C^{B}. The unknown locations {I'₁,....,I'_{T}} of sub-blocks with error bursts, as well as the non-zero syndrome values ⁱ₁, 0 ≦ i ≦ r₂-1 defined previously, are obtained from C^{B-}decoder 32. This decoder has the required decoding capability because the cumulative block syndrome polynomials (x) used at its input represent error patterns composed of at most S erasures and T random errors, and the design parameter B satisfies the inequality 2T + S ≦ B. By Lemma 1 it is known that the I-th sub-block has no error bursts if the block syndromes eⁱ₁, 0 ≦ i ≦ r₂-1 are all zero and in this case the C₁-estimated codeword ₗ,(x) is the decoded output which is passed through controller 35 to algebraic summing circuit 37. However, if this is not the case, i.e. the I-th sub-block has an error burst, then a further step is required.

This step, which is the last step in the decoding process of a sub-block with an error burst, is the processing of the complete string of syndromes eₗ(αⁱ), 0 ≦ i ≦ r₁ + r₂-1 by the decoder 39 for the RS-code C_{1,2} which has the parameters [n, n-r₁-r₂, r₁ + r₂ + 1], This complete string of syndromes is obtained by combining (at 39) the two disjoint strings of syndromes that have been computed in the steps previously described. The first substring of syndromes, eₗ(αⁱ), 0 ≦ i ≦r₁-1, is obtained in the first step of the decoding process as the Cᵢ-syndromes. The second substring, eₗ(α^{r}1^{+l} + ⁱ), 0 ≦ i ≦ r₂-1, is known as can easily be shown by writing the explicit equation for these values using (9):

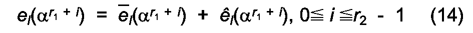

The terms ₁ (α^{r}l^{+ i}), 0 ≦ i ≦ r₂-1, at the right side of (14) are precisely the cumulative block syndromes eⁱ₁, 0 ≦ i ≦ r₂-1, which are obtained from the C^{B-}decoder 32. The remaining terms at the right side of (14), ₗ(α^{r}l ^{+ i}), 0 ≦ i ≦ r₂-1 are obtained by evaluating the error pattern estimate êₗ(x) which is computed by the C₁- decoder 22 at the locations α^{r}1 ^{+ i}, 0 ≦ i - r₂-1.

It will thus be seen that the decoding process described in this section and illustrated in Figs. 3A-D provides the complete set of syndromes {eₗ(αⁱ)}, 0 ≦ i ≦ r₁+ r₂-1 required by the [n, n-r₁-r₂, r₁ + r₂ + 1]-decoder 39, designated the C₁,₂-decoder. This decoder completes the process of correcting sub-blocks with error bursts by producing the error pattern e(x) which is subtracted (at 40) from ₁ (x) as shown in Fig. 3D.

It will now be apparent that if Sand T denote the number of sub-blocks with error bursts whose locations are respectively known and unknown, the disclosed arrangement is capable of locating and correcting all the combinations of sub-blocks with error bursts in a block for which the condition 2T + S ≦ B is true, where B is the number of buffers 15. This is achieved without lowering the sub-block level error correction capability by using the differences between the stored and the recomputed block check syndromes as block syndrome inputs to the RS-decoder 32.

It will also be seen that the architecture above-described requires the minimum number of check bytes for a selected error correction capability; namely, Nr₁ + Br₂ + r₃ where, as earlier stated, N is the number of sub-blocks per block, r₁ is the number of sub-block check bytes in the encoded sub-block, r₂ is the number of block check bytes in the block, and r₃ is that number of check bytes for the block check bytes sufficient to equally protect all of the bytes of the block, and where all combinations of T and S such that 2T S ≦ B must be provided for.

If, however, the constraint S = 0 is imposed (i.e., no externally generated pointers to sub-blocks are available), then this architecture may be modified and, as proved by Lemma 2 in the Appendix, the total number of check bytes can be decreased to 2t₁ N + 3(t₂-t₁)T + 2t₃ where t₁ and t₂ denote the number of desired correctable random errors at the sub-block and block levels, respectively; t₁ < t₂; t₃ is the maximum number of errors in the block check syndromes; and T is the desired number of correctable sub-blocks having burst errors to which no pointers are available.

### APPENDIX I

### LEMMA 1

The difference between the actual and the estimated error patterns produced by the C₁-decoder 22 represented as the error difference polynomial eₗ(x) is always a C₁-codeword. However, if it is non-zero because a miscorrection due to an error burst (i.e., an error exceeding the first level correction capability) has occurred, it is not a C₂-codeword and hence its C₂-syndrome bytes will be non-zero. These non-zero C₂-syndromes will be used to undo this miscorrection.

### PROOF

From Equations (6) and (8), it is known that ₗ(x) = cₗ(x) + eₗ(x) - (x) and in conjunction with (9) e₁ (x) = ₁ (x) - cₗ(x) is easilyobtained. Since both ₗ(x) and cₗ(x) are codewords in C₁, their difference e₁ (x) is also a codeword because C₁ is a linearcode. As stated above, if the I-th sub-block has no error bursts, then the actual and the estimated error patterns are identical and the difference is zero. In case the I-th sub-block has an error burst, its actual error pattern exceeds the correction capability of the C₁-decoder 22 and the estimated error pattern, in case of miscorrection, will differ from the actual one thus resulting in a non-zero difference.

Assume now that the actual pattern eₗ(x) consists of s erasures and t' random errors, where 2t' + s ≦ r₁ + r₂. In case of miscorrection the C₁-decoder 22 estimates an error pattern polynomial ₗ(x) whose errors are confined to the s erasures and furthermore to t" random errors such that 2t" + s ≦ r₁. The error pattern after miscorrection, ₗ (x), is the difference of the two; and thus its Hamming weight is at most s + t' + t" ≦ r₁ + ¦r₂/2¦ ≦ r₁ + r₂. Now consider the linear code C_{1,2} (in 39) which is specified by the encoder polynomial

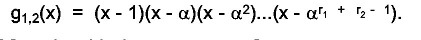

It is thus defined as the RS-code with the parameters [n, n-r₁-r₂, r₁ + r₂ + 1]; i.e., its minimal Hamming weight is r₁ + r₂ + 1. Since the Hamming weight of e₁ (x) is at most r₁ + r₂ it cannot be a codeword in C_{1,2}. However e₁(x) is a codeword in C₁ and since C_{1,2} is specified in terms of the non-overlapping spectral nulls of C₁ and C₂, it has been proved that it cannot be a codeword in C₂.

### APPENDIX II

### LEMMA 2

The total number of check bytes can be reduced to 2t₁ N + 3(t₂-t₁)T + 2t₃ because the block syndrome values ₁ (α^{r}1 ⁺ of an error difference polynomial eₗ(x) for a sub-block with an error burst are not all zero in the range 0≦i≦ |r₂/2 | -1.

### PROOF

From the proof of Lemma 1, it has been shown that e₁ (x) is a codeword in C₁ and furthermore that its Hamming weight is at most r₁ + r₂/2 | . Now assume that the converse is true; i.e., e₁ (α^{r}1 ^{+ i}) = 0, 0 ≦ i ≦ r₂/2 | - 1. Since e₁(x) is a codeword in C₁, (αⁱ) = 0, 0 ≦ i ≦ r₁ + r₂/2 | - 1. Hence ₁ (x) may be considered as a codeword in a [n, n-r₁-| r₂/2 |, r₁ + r₂/2 | + 1] - RS code. But this leads to a contradiction since from the proof of Lemma 1, it has been shown that the Hamming weight of ₁ (x) is at most r₁ + r₂/2 | and thus we have a non-zero value eⁱ₁ (α^{r}l ^{+ i}) ≠ 0, 0 ≦ i ≦ |r²/2 | -1.

Lemma 2 suggests that using the C^{B-}decoder 32, |r₂/2 | instead of r₂ times is sufficient to determine the locations of the sub-blocks with error bursts as well as their block syndromes e₁ , 0 ≦ i ≦ |r₂/2| -1. To compute the remaining half ⁱ₁, | r₂/2 | ≦ i ≦ r₂-1, of these syndromes, since their locations are already known, the C^{B-} decoder 32 requires only ⁱ₁ (α^{b}) = ΔAᵢ(b), |r₂/2 | ≦ i ≦ r₂-1, 0 ≦ b ≦ T-1 rather than 0 ≦ b ≦ B-1. Because B = 2T and r₂ = 2(t₂-t₁), it is unnecessary to compute the T(t₂-t₁) block check bytes ΔAᵢ(b), | r₂/2 | ≦ i ≦ r₂ - 1,T ≦ b ≦ B-1 and the total number of check bytes in the architecture can be reduced to 2t₁N + 3(t₂-t₁)T + 2t₃.

## Claims

1. A method of correcting multiple error bursts in data received in blocks - as, for example, read from data blocks recorded on a storage medium - each block comprising a plurality of sub-blocks of data bytes and sub-block check bytes, and block level syndromes from which block check syndromes are generated and stored after the last sub-block of the block, from which decoded and estimated block check syndromes are generated during reading, comprising the steps, after reception of the data, of:
algebraically summing the decoded block check syndromes and the estimated block check syndromes to provide a set of block check syndromes for a code for locating up to T sub-blocks having an error burst for which no externally generated pointers are available;
decoding the set of syndromes for identifying each the sub-block having an error burst; and
computing block level syndromes identifying the locations and the values of the errors within the sub-blocks having error bursts and no pointers.

2. A method as claimed in claim 1, further including algebraically summing the computed block level syndromes with the block level syndromes for the estimated error pattern to produce block level syndromes for the true error pattern for up to T sub-blocks having error bursts.

3. A method as claimed in claim 2, wherein the maximal number of errors that can be corrected in each such sub-block is (rᵢ+r₂)/2, where r₁ is the number of sub-block check bytes and r₂ is the number of block level syndromes.

4. A method as claimed in claim 2, wherein the minimum number of check bytes for a selected error correction capability is Nr₁ + Br₂ + r₃ where N is the number of sub-blocks per block, r₁ is the number of sub- block check bytes in the encoded sub-block, Br₂ is the number of block check syndromes in the block, and r₃ is that number of check bytes for the block check syndromes sufficient to equally protect all of the bytes of the block, and S and T denote respectively the number of correctable sub-blocks with error bursts for which externally generated pointers are and are not available, and where all combinations of T and S such that 2T + S Z B must be provided for.

5. A method as claimed in claim 4, wherein the total number of check bytes required is 2t,N + 3(t₂-tᵢ)T + 2t₃ where t₁ and t₂ denote the number of desired correctable random errors at the sub-block and block levels, respectively; t₁ < t₂; t₃ is the maximum number of errors in the r₂ block level syndromes; and T is the desired number of correctable sub-blocks having burst errors to which no pointers are available.

6. A method as claimed in any preceding claim, including, during initial compilation - for example, writing - of the data blocks, the steps of:
encoding the data in all sub-blocks of a block;
generating r₂ block level syndromes for the sub-blocks;
multiplying the r₂ syndromes by a series of preselected weighting factors (α^{l} ... a^{l}(^{B- 1)}) according to the location index I of the sub-block within the block;
storing each of the r₂ syndromes as multiplied by a respective weighting factor in a corresponding one of B buffers;
cumulatively summing the contents of the B buffers for all the sub-blocks within the block to produce Br₂ block check syndromes for that block;
after writing the last sub-block of the block, encoding the Br₂ block check syndromes to provide r₃ check bytes to protect the Br₂ block check syndromes; and
storing the factor weighted sums and r₃ check bytes as (Br₂ + r₃) block check syndromes.

7. A method as claimed in claim 6, including the further steps, during reception of the data, of:
buffering data as read from each sub-block of the block;
computing sub-block syndromes for each sub-block;
decoding those of the sub-block syndromes that do not correspond to a sub-block with an error burst for producing an estimated error pattern for each of the last-mentioned sub-blocks; and
correcting all correctable errors in the last-mentioned sub-blocks by algebraically summing their respective estimated error patterns with the buffered sub-block data as read to provide corrected sub- block data.

8. A method as claimed in claim 7, including the further steps, for each block, of:
computing block level syndromes from both the estimated error patterns and corrected sub-block data;
multiplying the block level syndromes for the corrected sub-block data by the series of preselected weighting factors (α^{!} ...α^{l(B- 1})) according to the location index of the sub-block within the block;
storing each syndrome as multiplied by a respective weighting factor in a corresponding one of B buffers;
cumulatively summing the contents of the B buffers as stored during the preceding step to produce estimated block check syndromes covering all sub-blocks of the block;
decoding the encoded block check syndromes as generated during initial compilation of the data blocks; and
then algebraically summing the decoded block check syndromes with the estimated block check syndromes to provide a set of block check syndromes for a code for locating sub-blocks having error bursts for which no externally generated pointers are available.

9. A method as claimed in claim 8, including the further steps, for each block, of:
decoding the set of block check syndromes to generate (up to T) algebraic pointers for identifying the sub-blocks with error bursts for which no externally generated pointers are available;
computing block level syndromes identifying any errors due to miscorrection during decoding of the sub-block syndromes; and
algebraically summing the computed block level syndromes identifying miscorrections with the block level syndromes computed from the estimated error pattern syndromes to generate the block level syndromes for a true error pattern.

10. A method as claimed in claim 9, further including correcting all sub-blocks without error bursts following generation of the algebraic pointers that locate all error bursts.

11. A method as claimed in claim 9, including the further steps, for each block, of:
buffering the computed sub-block syndromes;
decoding the buffered computed sub-block syndromes and the block level syndromes of the true error pattern, to generate an estimated burst error pattern; and
algebraically summing the estimated burst error pattern with the buffered data as read to correct all errors in the sub-blocks having error bursts.

12. Apparatus for correcting multiple error bursts in data by a method claimed in any preceding claim, the apparatus comprising:
means (31) operative following reception of the data for algebraically summing the decoded block check syndromes and the estimated block check syndromes to provide a set of block check syndromes for a code for locating sub-blocks having an error burst for which no externally generated pointer is available;
means (32) for decoding the set of block check syndromes for identifying each sub-block having an error burst; and
means (32) for computing block level syndromes identifying the locations and the values of the errors within the sub-blocks having error bursts and no pointers.

13. Apparatus as claimed in claim 12, further including:
means (10) operative during initial compilation of the data for encoding the data in all sub-blocks of a block;
means (11) for generating block level syndromes for the sub-blocks;
means (13) for multiplying the syndromes by a series of preselected weighting factors (a^{l} ... α^{l(B-1)}) according to the location index I of the sub-block within the block;
B buffers (15) each for storing a syndrome as multiplied by a different weighting factor;
means (14) for cumulatively summing the contents of the B buffers for all the sub-blocks within the block to produce block check syndromes for that block; and
means (17), operative after writing the last sub-block of the block, for encoding the last-mentioned block check syndromes to provide check bytes (r₃) for their protection so that the encoded sums and check bytes (r₂B + r₃) may be stored on the medium as block check syndromes.

14. Apparatus as claimed in claim 13, including:
means (18), operative during reception of the data, for buffering the data as received from each sub-block of the block;
means (19) for computing sub-block syndromes for each sub-block;
means (21,22) for decoding those of the sub-block syndromes that do not correspond to a sub-block with an error burst for producing an estimated error pattern for each of the last-mentioned sub-blocks; and
means (24) for correcting all correctable errors in the last-mentioned sub-blocks by algebraically summing their respective estimated error patterns with the buffered sub-block data as received to provide corrected sub-block data.

15. Apparatus as claimed in claim 14, further including:
means (26,27) for computing block level syndromes from the estimated error patterns (23) and corrected sub-block data (25);
means (28,13) for multiplying the block syndromes for the corrected sub-block data by the series of preselected weighting factors according to (a^{l} ... a^{l}(^{B- 1})) according to the location index I of the sub-block within the block, each syndrome as multiplied by a respective weighting factor being stored in a corresponding one of the B buffers (15);
means (14) for cumulatively summing contents of the B buffers (15) to produce estimated block check syndromes covering all sub-blocks of the block;
means (30) for decoding the encoded block check syndromes as generated during initial compilation of the data blocks; and
means (31) for algebraically summing the decoded block check syndromes with the estimated block check syndromes to provide a set of block check syndromes for a code for locating sub-blocks having error bursts for which no externally generated pointers are available.

16. Apparatus as claimed in claim 15, further including:
means (32) for decoding the set of syndromes and generating algebraic pointers for identifying the sub-blocks with error bursts;
means (32) for computing block level syndromes identifying any errors due to miscorrection during decoding of the sub-block syndromes; and
means (33) for algebraically summing the computed block level syndromes identifying miscorrections with the block level syndromes computed from the estimated error pattern syndromes to generate the block level syndromes for a true error pattern.

17. Apparatus as claimed in claim 16, including means (35,37) for correcting all sub-blocks without error bursts following generation of the algebraic pointers that locate all error bursts.

18. Apparatus as claimed in claim 17, including:
means (20) for buffering the computed sub-block syndromes;
means (39) for decoding the buffered computed sub-block syndromes and the block level syndromes of the true error pattern, to generate an estimated burst error pattern; and
means (40) for algebraically summing the estimated burst error pattern with the buffered data as read to correct all errors in the sub-blocks having error bursts.

## Patentansprüche

1. Ein Verfahren zur Korrektur zahlreicher Fehlerpakete in Daten, die in Blöcken empfangen wurden - wie, zum Beispiel, aus Datenblöcken gelesen wurden, die in einem Speichermedium aufgezeichnet wurden - wobei jeder Block eine Vielzahl von Unterblöcken mit Datenbytes und Unterblock-Prüfbytes enthält, und Blockstufensyndrome, aus denen Blockprüfsyndrome generiert und nach dem letzten Unterblock des Blocks gespeichert werden, aus denen decodierte und geschätzte Blockprüfsyndrome während des Lesens generiert werden, die nach dem Empfang von Daten Schritte enthalten, um
die decodierten Blockprüfsyndrome und die geschätzten Blockprüfsyndrome algebraisch zu summieren, um einen Satz von Blockprüfsyndromen für einen Code zur Lokalisierung bis zu T Unterblöcken bereitzustellen, die ein Fehlerpaket haben, für das keine extern generierten Zeiger verfügbar sind;
den Satz von Syndromen zur Identifizierung jedes Unterblocks mit einem Fehlerpaket zu decodieren; und
Blockstufensyndrome zu berechnen, welche die Speicherstellen und die Werte der Fehler innerhalb der Unterblöcke berechnen, die Fehlerpakete und keine Zeiger haben.

2. Ein Verfahren wie in Anspruch 1 angemeldet, das außerdem die berechneten Blockstufensyndrome mit den Blockstufensyndromen für das geschätzte Fehlermuster algebraisch summiert, um Blockstufensyndrome für das wahre Fehlermuster für bis zu T Unterblöcke mit Fehlerpaketen zu erzeugen.

3. Ein Verfahren wie in Anspruch 2 angemeldet, wobei die maximale Anzahl von Fehlern, die in jedem Unterblock korrigiert werden kann, (rᵢ+r₂)/2 beträgt, wobei r₁ die Anzahl von Unterblock-Prüfbytes und r₂ die Anzahl von Blockstufensyndromen ist.

4. Ein Verfahren wie in Anspruch 2 angemeldet, wobei die Mindestanzahl von Prüfbytes für eine ausgewählte Fehlerkorrekturfähigkeit Nr₁ + Br₂ + r₃ beträgt, wobei N die Anzahl von Unterblöcken pro Block ist, r₁ die Anzahl von Unterblock-Prüfbytes in dem codierten Unterblock ist, Br₂ die Anzahl von Blockprüfsyndromen in dem Block ist, und r₃ die Anzahl von Prüfbytes für die Blockprüfsyndrome ist, ausreichend, um ebenfalls alle Bytes des Blocks zu schützen, und wo alle Kombinationen von S und Tjeweils die Anzahl von korrigierbaren Unterblöcken mit Fehlerpaketen bezeichnen, für die extern generierte Zeiger verfügbar und nicht verfügbar sind, und wo alle Kombinationen von T und S sind, so daß 2T + S ≦ B hierfür bereitgestellt werden müssen.

5. Ein Verfahren wie in Anspruch 4 angemeldet, wobei die Gesamtanzahl von erforderlichen Prüfbytes 2t,N + 3(t₂-tᵢ)T + 2t₃ ist, wobei t₁ und t₂ die Anzahl von gewünschten, korrigierbaren Zufallsfehlern in dem Unterblock beziehungsweise den Blockstufen bezeichnet; t₁ < t₂; t₃ die maximale Anzahl von Fehlern in den Blockprüfsyndromen ist; und T die gewünschte Anzahl von korrigierbaren Unterblöcken mit Burstfehlern ist, in denen keine Zeiger verfügbar sind.

6. Ein Verfahren wie in irgendeinem der vorhergehenden Ansprüche angemeldet, das während derAnfangskompilation von Datenblöcken, zum Beispiel Schreiben, Schritte enthält, um die Daten in allen Unterblöcken eines Blocks zu codieren;
r₂ Blockstufensyndrome für die Unterblöcke zu generieren;
die r₂ Syndrome mit einer Reihe von zuvor ausgewählten, gewichteten Faktoren (a¹ ... α^{l(B- 1)}) gemäß dem Speicherstellenindex 1 des Unterblocks innerhalb des Blocks zu multiplizieren;
jedes der r₂ Syndrome, wie mit einem entsprechenden, gewichteten Faktor multipliziert, in einem der entsprechenden B Puffer zu speichern;
die Inhalte der B Puffer für alle Unterblöcke innerhalb des Blocks kumulativ zu summieren, um Br₂ Blockprüfsyndrome für diesen Block zu erzeugen;
nach dem Schreiben des letzten Unterblocks von dem Block die Br₂ Blockprüfsyndrome zu codieren, um r₃ Prüfbytes zum Schutze der Br₂ Blockprüfsyndrome bereitzustellen; und
die nach Faktoren gewichteten Summen und r₃ Prüfbytes als (Br₂ + r₃) Blockprüfsyndrome zu speichern.

7. Ein Verfahren wie in Anspruch 6 angemeldet, einschließlich der zusätzlichen Schritte während des Datenempfangs zum:
Puffern von Daten wie diese aus jedem Unterblock des Blocks gelesen werden;
Berechnen von Unterblocksyndromen für jeden Unterblock;
Decodieren von jenen Unterblocksyndromen, die keinem Unterblock mit einem Fehlerpaket zur Erzeugung eines geschätzten Fehlermusters für jede der zuletzt erwähnten Unterblöcke entsprechen; und
Korrigieren aller korrigierbarer Fehler in den zuletzt erwähnten Unterblöcken, indem deren entsprechenden geschätzten Fehlermuster mit den gepufferten Unterblockdaten, wie gelesen, algebraisch summiert werden, um korrigierte Unterblockdaten bereitzustellen.

8. Ein Verfahren wie in Anspruch 7 angemeldet, das zusätzlich für jeden Block Schritte enthält, um
Blockstufensyndrome sowohl aus den geschätzten Fehlermustern als auch aus den korrigierten Unterblockdaten zu berechnen;
die Blockstufensyndrome für die korrigierten Unterblockdaten mit Serien von zuvor ausgewählten, gewichteten Faktoren (α¹ ...α^{1(b- 1)}) gemäß dem Speicherstellenindex des Unterblocks innerhalb des Blocks zu multiplizieren;
jedes Syndrom - wie dieses mittels eines entsprechenden gewichteten Faktors in einem der entsprechenden B Puffer multipliziert wurde - zu speichern;
die Inhalte der B Puffer - wie während des vorhergehenden Schritts gespeichert - kumulativ zu summieren, um geschätzte Blockprüfsyndrome zu erzeugen, die alle Unterblöcke des Blocks abdecken;
die codierten Blockprüfsyndrome - wie diese während der Anfangskompilation der Datenblöcke generiert wurden - zu decodieren; und
anschließend die decodierten Blockprüfsyndrome mit den geschätzten Blockprüfsyndromen algebraisch zu summieren, um einen Satz von Blockprüfsyndromen für einen Code bereitzustellen, um Unterblöcke mit Fehlerpaketen zu lokalisieren, für die keine extern generierten Zeiger verfügbar sind.

9. Ein Verfahren wie in Anspruch 8 angemeldet, das für jeden Block die zusätzlichen Schritte enthält, um den Satz von Blockprüfsyndromen zu decodieren, um algebraische Zeiger (bis zu T) zur Identifzierung der Unterblöcke mit Fehlerpaketen zu generieren, für die keine extern generierten Zeiger verfügbar sind;
die Blockprüfsyndrome zu berechnen, die jeden Fehler aufgrund von Fehlkorrektur während des Decodierens der Unterblocksyndromen identifizieren; und
die berechneten Blockstufensyndrome, welche Fehlkorrekturen kennzeichnen, mit den Blockprüfsyndromen algebraisch zu summieren, die aus den geschätzten Fehlermustersyndromen berechnet wurden, um die Blockstufensyndrome für ein wahres Fehlermuster zu generieren.

10. Ein Verfahren wie in Anspruch 9 angemeldet, das zusätzlich die Korrektur aller Unterblöcke ohne Fehlerpakete enthält, die im Anschlußan die Generierung der algebraischen Zeiger folgt, die alle Fehlerpakete lokalisiert.

11. Ein Verfahren wie in Anspruch 9 angemeldet, das zusätzlich für jeden Block Schritte enthält, um
die berechneten Unterblocksyndrome zu puffern;
die gepufferten, berechneten Unterblocksyndrome und die Blockstufensyndrome der wahren Fehlermuster zu decodieren, um ein geschätztes Fehlerpaketmuster zu erzeugen; und
die geschätzten Fehlerpaketmuster mit den gepufferten Daten, wie diese gelesen wurden, algebraisch zu summieren, um alle Fehler in den Unterblöcken mit Fehlerpaketen zu korrigieren.

12. Apparat zur Korrektur zahlreicher Fehlerpakete in Daten mittels eines Verfahrens, das in irgendeinem der vorhergehenden Ansprüche angemeldet ist, wobei der Apparat enthält:
Mittel (31), die funktionsfähig sind, um im Anschluß an den Empfang von Daten, die decodierten Blockprüfsyndrome und die geschätzten Blockprüfsyndrome algebraisch zu summieren, um einen Satz von Blockprüfsyndromen für einen Code zur Lokalisierung von Unterblöcken mit Fehlerpaketen bereitzustellen, für welche kein extern generierter Zeiger verfügbar ist;
Mittel (32) zum Decodieren des Satzes von Blockprüfsyndromen, um jeden Unterblock mit einem Fehlerpaket zu identifizieren; und
Mittel (32) zum Berechnen von Blockstufensyndromen, um die Speicherstellen und Werte der Fehler innerhalb der Unterblöcke mit Fehlerpaketen und ohne Zeiger zu identifizieren.

13. Apparat wie in Anspruch 12 angemeldet, der außerdem enthält:
Mittel (10), die funktionsfähig sind, um während der Anfangskompilation von Daten, Daten in allen Unterblöcken von einem Block zu codieren;
Mittel (11), um Blockstufensyndrome für die Unterblöcke zu generieren;
Mittel (13), um die Syndrome mit einer Reihe von zuvor ausgewählten, gewichteten Faktoren (a^{l} ... α^{1(b -1)}) gemäß dem Speicherstellenindex 1 des Unterblocks innerhalb des Blocks zu multiplizieren;
B Puffer (15), jeder zum Speichern eines Syndroms, wie dieses mit einem unterschiedlichen, gewichteten Faktor multipliziert wurde;
Mittel (14), um die Inhalte der B Puffer für alte Unterblöcke innerhalb des Blocks kumulativ zu summieren, um Blockprüfsyndrome für diesen Block zu erzeugen; und
Mittel (17), die funktionsfähig sind,.um nach dem Schreiben des letzten Unterblocks von dem Block die zuletzt erwähnten Blockprüfsyndrome zu codieren, um Prüfbytes (r₃) zu derem Schutz bereitzustellen, so daß die codierten Summen und Prüfbytes (r₂B + r₃) als Blockprüfsyndrome in dem Medium gespeichert werden können.

14. Apparat wie in Anspruch 13 angemeldet, einschließlich
Mitteln (18), die funktionsfähig sind, um während des Empfangs von Daten, die Daten, wie diese von dem Unterblock des Blocks empfangen wurden, zu puffern;
Mitteln (19), um Unterblocksyndrome für jeden Unterblock zu berechnen;
Mitteln (21, 22), um jene Unterblocksyndrome zu decodieren, die keinem Unterblock mit einem Fehlerpaket entsprechen, um ein geschätztes Fehlermuster für jeden der zuletzt erwähnten Unterblöcke zu erzeugen; und
Mittel (24), um alle korrigierbaren Fehler in den zuletzt erwähnten Unterblöcken zu korrigieren, indem ihre jeweiligen geschätzten Fehlermuster algebraisch zu den gepufferten Unterblockdaten summiert werden, die empfangen wurden, um die korrigierten Unterblockdaten bereitzustellen.

15. Apparat wie in Anspruch 14 angemeldet, der außerdem enthält:
Mittel (26, 27) zum Berechnen der Blockstufensyndrome aus den geschätzten Fehlermustern (23) und den korrigierten Unterblockdaten (25);
Mittel (28, 13), um die Blocksyndrome für die korrigierten Unterblockdaten mittels Serien von zuvor ausgewählten, gewichteten Faktoren gemäß (a^{l} ... a1(B- ¹» und gemäß dem Speicherstellenindex 1 des Unterblocks innerhalb des Blocks zu multiplizieren, wobei jedes Syndrom, wie dieses mittels eines entsprechenden gewichteten Faktors multipliziert wurde, in einem der entsprechenden B Puffer (15) gespeichert wird;
Mittel (14) um Inhalte der B Puffer (15) kumulativ zu summieren, um geschätzte Blockprüfsyndrome zu erzeugen, welche alle Unterblöcke des Blocks abdecken;
Mittel (30) zum Decodieren der codierten Blockprüfsyndrome, wie diese während der Anfangskompilation der Datenblöcke generiert wurden; und
Mittel (31), um die decodierten Blockprüfsyndrome mit den geschätzten Blockprüfsyndromen algebraisch zu summieren, um einen Satz von Blockprüfsyndromen für einen Code bereitzustellen, um Unterblöcke mit Fehlerpaketen zu lokalisieren, für die keine extern generierten Zeiger verfügbar sind.

16. Apparat wie in Anspruch 15 angemeldet, der außerdem enthält:
Mittel (32) zum Decodieren des Satzes von Syndromen und zur Generierung von algebraischen Zeigern, um die Unterblöcke mit Fehlerpaketen zu kennzeichnen;
Mittel (32), um Blockstufensyndrome zu berechnen, die jeden Fehler infolge Fehlkorrektur während des Decodierens der Unterblocksyndrome identifizierem; und
Mittel (33), um die berechneten Blockstufensyndrome, welche Fehlkorrekturen anzeigen, mit den aus den geschätzten Fehlermustersyndromen berechneten Blockstufensyndrome algebraisch zu summieren, um die Blockstufensyndrome für ein wahres Fehlermuster zu generieren.

17. Apparat wie in Anspruch 16 angemeldet, der Mittel (35, 37) zur Korrektur von allen Unterblöcken ohne Fehlerpakete enthält, die im Anschluß an die Generierung der algebraischen Zeiger erfolgt, die alle Fehlerpakete lokalisieren.

18. Apparat wie in Anspruch 17 angemeldet, der enthält:
Mittel (20) zum Puffern der berechneten Unterblocksyndrome;
Mittel (39) zum Decodieren der gepufferten, berechneten Unterblocksyndrome und der Blockstufensyndrome der wahren Fehlermuster, um ein geschätztes Burstfehlermuster zu generieren; und
Mittel (40), um die geschätzten Burstfehlermuster mit den gepufferten Daten, wie diese gelesen wurden, algebraisch zu summieren, um alle Fehler in den Unterblöcken mit Fehlerpaketen zu korrigieren.

## Revendications

1. Une méthode de correction de paquets d'erreurs multiples dans des données reçues par blocs comme, par exemple, les données lues à partir de blocs de données enregistrés sur un milieu d'emmagasinage, chaque bloc comprenant une pluralité de sous-blocs de multiplets de données et de multiplets de vérification de sous-blocs, et des syndromes de niveaux de blocs à partir desquels sont générés et emmagasinés des syndromes de vérification de blocs après le dernier sous-bloc du bloc, d'où sont générés, pendant la lecture, des syndromes de vérification de blocs décodés et estimés, comprenant, après réception des données, les étapes suivantes:
- l'addition algébrique des syndromes de vérification de blocs décodés et des syndromes de vérification de blocs estimés pour obtenir un ensemble de syndromes de vérification de blocs pour un code afin de localiser jusqu'à T sous-blocs présentant un paquet d'erreurs pour lequel aucun pointeur généré extérieurement n'est disponible;
- le décodage de l'ensemble de syndromes pour identifier chaque sous-bloc présentant un paquet d'erreurs; et
- le calcul de syndromes de niveaux de blocs identifiant les emplacements et les valeurs des erreurs dans les sous-blocs présentant des paquets d'erreurs et pas de pointeurs.

2. Une méthode selon la revendication 1 comprenant en outre l'addition algébrique des syndromes de niveaux de blocs calculés et des syndromes de niveaux de blocs pour la configuration d'erreur estimée afin de produire des syndromes de niveaux de blocs pour la configuration d'erreur vraie pour jusqu'à T sous-blocs présentant des paquets d'erreurs.

3. Une méthode selon la revendication 2 dans laquelle le nombre maximal d'erreurs pouvant être corrigées dans chacun de ces sous-blocs est égal à (rᵢ + r₂) où r₁ est le nombre de multiplets de vérification de sous-blocs et r₂ est le nombre de syndromes de niveaux de blocs.

4. Une méthode selon la revendication 2 dans laquelle le nombre minimal de multiplets de vérification pour une capacité de correction d'erreurs sélectionnée est égal à Nr₁ + Br₂ + r₃ où N est le nombre de sous-blocs par bloc, r₁ est le nombre de multiplets de vérification de sous-blocs dans le sous-bloc codé, Br₂ est le nombre de syndromes de vérification de blocs dans le bloc, et r₃ est le nombre de multiplets de vérification pour les syndromes de vérification de blocs suffisant pour protéger également tous les multiplets du bloc, et S et T indiquent respectivement le nombre de sous-blocs pouvant être corrigés avec des paquets d'erreurs pour lesquels des pointeurs générés extérieurement sont et ne sont pas disponibles, et où toutes les combinaisons de T et de S de façon que 2T + S ≦ B doivent être prévues.

5. Une méthode selon la revendication 4 dans laquelle le nombre total de multiplets de vérification requis est égal à 2t,N + 3(t₂ - tᵢ)T + 2t₃ où t₁ et t₂ indiquent le nombre d'erreurs aléatoires corrigibles désirées aux niveaux des sous-blocs et des blocs, respectivement; t₁ < t₂; t₃ est le nombre maximal d'erreurs dans les r₂ syndromes de niveaux de blocs; et T est le nombre désiré de sous-blocs corrigibles présentant des erreurs multiples pour lesquelles aucun pointeur n'est disponible.

6. Une méthode selon l'une quelconque des revendications précédentes, comprenant pendant la compilation initiale des blocs de données, par exemple l'écriture, les étapes suivantes:
- le codage des données dans tous les sous-blocs d'un bloc;
- la génération de r₂ syndromes de niveaux de blocs pour les sous-blocs;
- la multiplication des r₂ syndromes par un série de facteurs de pondération présélectionnés (a¹ ...α^{l(B- 1)}) selon l'index d'emplacement 1 du sous-bloc dans le bloc;
- l'emmagasinage de chacun des r₂ syndromes multipliés par un facteur de pondération respectif dans une mémoire correspondante des B mémoires intermédiaires;
- l'addition cumulative du contenu des B mémoires intermédiaires pour tous les sous-blocs dans le bloc afin de produire Br₂ syndromes de vérification de blocs pour ce bloc;
- après l'écriture du dernier sous-bloc du bloc, le codage des Br₂ syndromes de vérification de blocs afin de fournir r₃ multiplets de vérification pour protéger les Br₂ syndromes de vérification de blocs; et
- l'emmagasinage des sommes pondérées et de r₃ multiplets de vérification comme les (Br₂ + r₃) syndromes de vérification de blocs.

7. Une méthode selon la revendication 6 comprenant, pendant la réception des données, les étapes supplémentaires suivantes:
- la mise en mémoires intermédiaires des données telles que lues depuis chaque sous-bloc du bloc;
- le calcul de syndromes de sous-blocs pour chaque sous-bloc;
- le décodage des syndromes de sous-blocs qui ne correspondent pas à un sous-bloc avec un paquet d'erreurs afin de produire une configuration d'erreur estimée pour chacun des derniers sous-blocs mentionnés; et
- la correction de toutes les erreurs corrigibles dans les derniers sous-blocs mentionnés par l'addition algébrique de leurs configurations d'erreurs estimées respectives et des données de sous-blocs mises en mémoires intermédiaires telles que lues afin de fournir des données de sous-blocs corrigées.

8. Une méthode selon la revendication 7 comprenant, pour chaque bloc, les étapes supplémentaires suivantes:
- le calcul de syndromes de niveaux de blocs à partir des configurations d'erreurs estimées et des données de sous-blocs corrigées;
- la multiplication des syndromes de niveaux de blocs pour les données de sous-blocs corrigées par la série de facteurs de pondération présélectionnés (a¹ ... α^{1(B-1)}) selon l'index d'emplacement du sous-bloc dans le bloc;
- l'emmagasinage de chaque syndrome tel que multiplié par un facteur de pondération respectif dans une mémoire correspondante de B mémoires intermédiaires;
- l'addition cumulative des contenus des B mémoires intermédiaires tels qu'emmagasinés pendant l'étape précédente pour produire des syndromes de vérification de blocs estimés couvrant tous les sous-blocs du bloc;
- le décodage des syndromes de vérification de blocs codés tels que générés pendant la compilation initiale des blocs de données et ensuite,
- l'addition algébrique des syndromes de vérification de blocs décodés et des syndromes de vérification de blocs estimés pour obtenir un ensemble de syndromes de vérification de blocs pour un code afin de localiser des sous-blocs présentant des paquets d'erreurs pour lesquels aucun pointeur extérieurement généré n'est disponible.

9. Une méthode selon la revendication 8 comprenant, pour chaque bloc, les étapes supplémentaires suivantes:
- le décodage de l'ensemble de syndromes de vérification de blocs pour générer des pointeurs algébriques (jusqu'à T) afin d'identifier les sous-blocs présentant des paquets d'erreurs pour lesquels aucun pointeur extérieurement généré n'est disponible;
- le calcul de syndromes de niveaux de blocs identifiant toutes erreurs dues à une mauvaise correction pendant lé décodage des syndromes de sous-blocs; et
- l'addition algébrique des syndromes de niveaux de blocs calculés identifiant des corrections défectueuses et des syndromes de niveaux de blocs calculés à partir des syndromes de configuration d'erreur estimés afin de générer les syndromes de niveaux de blocs pour une configuration d'erreur vraie.

10. Une méthode selon la revendication 9 comprenant en outre la correction de tous les sous-blocs sans paquet d'erreurs à la suite de la génération des pointeurs algébriques qui localisent tous les paquets d'erreurs.

11. Une méthode selon la revendication 9 comprenant, pour chaque bloc, les étapes supplémentaires suivantes:
- la mise en mémoires intermédiaires des syndromes de sous-blocs calculés;
- le décodage des syndromes de sous-blocs calculés mis en mémoires intermédiaires et des syndromes de niveaux de blocs de la configuration d'erreur vraie, afin de générer une configuration d'erreurs multiples estimée; et
- l'addition algébrique de la configuration d'erreurs multiples estimée et des données mises en mémoires intermédiaires telles que lues afin de corriger toutes erreurs dans les sous-blocs présentant des paquets d'erreurs.

12. Appareil pour corriger des paquets d'erreurs multiples dans des données par l'application d'une méthode selon l'une quelconque des revendications précédentes, l'appareil comprenant:
- des moyens (31) actifs à la suite de la réception des données pour additionner algébriquement les syndromes de vérification de blocs décodés et les syndromes de vérification de blocs estimés pour donner un ensemble de syndromes de vérification de blocs pour un code afin de localiser des sous-blocs présentant un paquet d'erreurs pour lequel aucun pointeur extérieurement généré n'est disponible;
- des moyens (32) pour décoder l'ensemble de syndromes de vérification de blocs afin d'identifier chaque sous-bloc présentant un paquet d'erreurs; et
- des moyens (32) pour calculer des syndromes de niveaux de blocs identifiant les emplacements et les valeurs des erreurs dans les sous-blocs présentant des paquets d'erreurs et pas de pointeurs.

13. Appareil selon la revendication 12 comprenant en outre:
- des moyens (10) actifs pendant la compilation initiale des données pour coder les données dans tous les sous-blocs d'un bloc;
- des moyens (11) pour générer des syndromes de niveaux de blocs pour les sous-blocs;
- des moyens (13) pour multiplier les syndromes par une série de facteurs de pondération présélectionnés (a¹ ... a^{l}(^{B-} 1» selon l'index d'emplacement 1 du sous-bloc dans le bloc;
- B mémoires intermédiaires (15), chacune d'elles étant prévue pour emmagasiner un syndrome tel que multiplié par un facteur de pondération différent;
- des moyens (14) pour additionner cumulativement les contenus des B mémoires intermédiaires pour tous les sous-blocs dans le bloc afin de produire des syndromes de vérification de blocs pour ce bloc; et
- des moyens (17) actifs après l'écriture du dernier sous-bloc du bloc, afin de coder les syndromes de vérification de blocs mentionnés en dernier pour fournir des multiplets de vérification (r₃) pour leur protection de façon que les sommes codées et les multiplets de vérification (r₂B + r₃) puissent être emmagasinés sur le milieu comme des syndromes de vérification de blocs.

14. Appareil selon la revendication 13, comprenant:
- des moyens (18) actifs pendant la réception des données, pour mettre en mémoires intermédiaires les données telles que reçues depuis chaque sous-bloc du bloc;
- des moyens (19) pour calculer des syndromes de sous-blocs pour chaque sous-bloc;
- des moyens (21,22) pour décoder les syndromes de sous-blocs qui ne correspondent pas à un sous-bloc avec un paquet d'erreurs afin de produire une configuration d'erreur estimée pour chacun des sous-blocs mentionnés en dernier; et
- des moyens (24) pour corriger toutes les erreurs corrigibles dans les sous-blocs mentionnés en dernier en additionnant algébriquement leurs configurations d'erreurs estimées respectives et les données de sous-blocs mises en mémoires intermédiaires telles que reçues afin de fournir des données de sous-blocs corrigées.

15. Appareil selon la revendication 14, comprenant en outre:
- des moyens (26, 27) pour calculer des syndromes de niveaux de blocs à partir des configurations d'erreurs estimées (23) et des données de sous-blocs corrigés (25);
- des moyens (28,13) pour multiplier les syndromes de blocs pour les données de sous-blocs corrigées par la série de facteurs de pondération présélectionnés selon (a¹ ... al(B- 1» selon l'index d'emplacement 1 du sous-bloc dans le bloc, chaque syndrome tel que multiplié par un facteur de pondération respectif étant emmagasiné dans une mémoire correspondante des B mémoires intermédiaires (15);
- des moyens (14) pour additionner cumulativement les contenus des B mémoires intermédiaires (15) afin de produire des syndromes de vérification de blocs estimés couvrant tous les sous-blocs du bloc;
- des moyens (30) pour décoder les syndromes de vérification de blocs codés tels que générés pendant la compilation initiale des blocs de données; et
- des moyens (31) pour additionner algébriquement les syndromes de vérification de blocs décodés et les syndromes de vérification de blocs estimés pour fournir un ensemble de syndromes de vérification de blocs pour un code afin de localiser des sous-blocs présentant des paquets d'erreurs pour lesquels aucun pointeur extérieurement généré n'est disponible.

16. Appareil selon la revendication 15 comprenant en outre:
- des moyens (32) pour décoder l'ensemble de syndromes et générer des pointeurs algébriques pour identifier les sous-blocs présentant des paquets d'erreurs;
- des moyens (32) pour calculer des syndromes de niveaux de blocs identifiant toutes erreurs dues à une mauvaise correction pendant le décodage des syndromes de sous-blocs; et
- des moyens (33) pour additionner algébriquement les syndromes de niveaux de blocs calculés identifiant des corrections défectueuses et les syndromes de niveaux de blocs calculés à partir des syndromes de configurations d'erreurs estimés afin de générer les syndromes de niveaux de blocs pour une configuration d'erreur vraie.

17. Appareil selon la revendication 16 comprenant des moyens (35, 37) pour corriger tous les sous-blocs sans paquet d'erreurs à la suite de la génération des pointeurs algébriques qui localisent tous les paquets d'erreurs.

18. Appareil selon la revendication 17 comprenant:
- des moyens (20) pour mettre en mémoire intermédiaire les syndromes de sous-blocs calculés;
- des moyens (39) pour décoder les syndromes de sous-blocs calculés mis en mémoires intermédiaires et les syndromes de niveaux de blocs de la configuration d'erreurs vraie, afin de générer une configuration d'erreurs multiples estimée; et
- des moyens (40) pour additionner algébriquement la configuration d'erreurs multiples estimée et les données de mémoires intermédiaires telles que lues afin de corriger toutes les erreurs dans les sous-blocs présentant des paquets d'erreurs.
